# EUROPÄISCHE PATENTSCHRIFT

(11) **EP 1 068 104 B1**
(45) Veröffentlichungstag und Bekanntmachung des Hinweises auf die Patenterteilung: **02.07.2003**
(21) Anmeldenummer: 99924711.7
(22) Anmeldetag: 26.03.1999
(51) Int. Cl.: B60R 21/00

(54) **VERFAHREN ZUM BETREIBEN EINES ÜBER EINE BUSLEITUNG VERNETZTEN RÜCKHALTESYSTEMS BEI EINEM KURZSCHLUSS**
METHOD FOR OPERATING A RESTRAINT SYSTEM CONNECTED BY A BUS LINE IN CASE OF A SHORT CIRCUIT
PROCEDE PERMETTANT DE FAIRE FONCTIONNER UN SYSTEME DE RETENUE CONNECTE A UNE LIGNE DE BUS EN CAS DE COURT-CIRCUIT

(30) Priorität: 28.03.1998 DE 19813922
(43) Veröffentlichungstag der Anmeldung: 17.01.2001
(73) Patentinhaber: ROBERT BOSCH GMBH, 70442 Stuttgart (DE); Conti Temic microelectronic GmbH, 90411 Nürnberg (DE)
(72) Erfinder: NITSCHKE, Werner, D-71254 Ditzingen (DE); KARL, Otto, D-71229 Leonberg (DE); BAUER, Joachim, D-71720 Oberstenfeld-Prevorst (DE); BISCHOFF, Michael, D-85111 Adelschlag (DE); FENDT, Günter, D-86529 Schrobenhausen (DE); RINKENS, Johannes, D-85055 Ingolstadt (DE); SCHÄFFER, Stefan, D-86529 Schrobenhausen (DE)
(86) Internationale Anmeldenummer: DE9900938
(87) Internationale Veröffentlichungsnummer: WO99050102

(56) Entgegenhaltungen:
- DE-A- 19 647 668
- DE-C- 19 503 460
- DE-C- 19 625 401

## Beschreibung

### Stand der Technik

Die vorliegende Erfindung betrifft ein Verfahren zum Betreiben eines über eine Busleitung vernetzten Rückhaltesystems bei einem Kurzschluß auf der Busleitung, wobei an die Busleitung eine zentrale Steuereinheit und mehrere Datenverarbeitungseinheiten angekoppelt sind, von denen jede zur Ansteuerung ein oder mehrerer Rückhalteeinrichtungen vorgesehen ist. Ein solches verfahre ist aus dem Dokument DE-C-196 25 401 bekannt.

Die Leistungsfähigkeit der Rückhaltesysteme in Fahrzeugen wird künftig stark zunehmen, um den Schutz der Fahrzeuginsassen weiter zu verbessern. Das bedeutet, daß die Zahl der Rückhalteeinrichtungen und deren zugehörige Auslösemittel im Fahrzeug drastisch ansteigen wird. Zu diesen Rückhalteeinrichtungen gehören dann z.B. mehrstufig zündbare Airbags für den Fahrer und Beifahrer, Kniebags für Fahrer und Beifahrer, Seitenairbags für Fahrer, Beifahrer und Fond-Insassen, wobei Seitenairbags sowohl für den Kopfals auch Toraxbereich vorgesehen werden können, Gurtstrammer, die auch mehrstufig aktivierbar sind, eventuell auch Überrollbügel etc.. Es wird also für jeden Fahrzeuginsassen ein komplexes Schutzsystem, das aus mehreren Rückhalteeinrichtungen besteht, im Fahrzeug installiert sein.

In der älteren deutschen Patentanmeldung 196 47 668.2 und in den Conference Proceedings des SAE International Congress & Exposition, 24. - 27.02.97, Detroit wird in dem Beitrag "Bussystem zur Vernetzung von Aktuatoren für Rückhaltesysteme" von J. Bauer, G. Mehler, W. Nitschke ein komplexes Rückhaltesystem beschrieben. Durch Einführung eines Bussystems, daß alle Rückhalteeinrichtungen miteinander vernetzt, konnten voluminöse Kabelbäume eingespart werden. Für jede Rückhalteeinrichtung ist bei diesem bekannten System eine Datenverarbeitungseinheit vorgesehen, die im wesentlichen eine Recheneinheit, Daten-Eingangs- und Ausgangsschaltungen, eine Speichereinheit, eine Zeit- und Taktbasis und eine Stromversorgung aufweist. Diese auch als periphere intelligente Zündendstufe bezeichnete Datenverarbeitungseinheit ist in unmittelbarer Nähe des zu der jeweiligen Rückhalteeinrichtung gehörenden Auslösemittels, nämlich in einem Zündpillenstecker oder einem Substrat der Zündpille selbst, angeordnet.

Von einer zentralen Steuereinheit aus erhält jede Datenverarbeitungseinheit über eine Busleitung ihre Versorgungsenergie. Außerdem ermittelt die zentrale Steuereinheit anhand mehrerer Steuersignale - z.B von Beschleunigungssensoren, Precrashsensoren, Sitzbelegungssensoren - welche Rückhalteeinrichtungen auszulösen sind. Dementsprechend adressiert die zentrale Steuereinheit mit Hilfe eines über die Busleitung übertragenen Protokolls die betroffenen Datenverarbeitungseinheiten. Auch Diagnoseanforderungen gehen von der zentralen Steuereinheit aus über die Busleitung an die einzelnen Datenverarbeitungseinheiten, welche ihre Diagnoseantworten wiederum an die zentrale Steuereinheit über den Bus zurücksenden.

Wie schon in der älteren deutschen Patentanmeldung 196 47 668.2 angesprochen, sollte bei einem auf der Busleitung auftretenden Kurzschluß nach Möglichkeit verhindert werden, daß dadurch das ganze Rückhaltesystem ausfällt. Deshalb führt die zentrale Steuereinheit eine Kurzschlußstrommessung auf der Busleitung durch und lokalisiert durch Interaktion mit den an der Busleitung angschlossenen Datenverarbeitungseeinrichtungen den Kurzschluß. Dadurch wird es möglich, daß zumindest alle zwischen der zentralen Steuereinheit und dem Kurzschluß liegenden Datenverarbeitungseinrichtungen funktionsfähig bleiben und lediglich die nach dem Kurzschluß liegenden Datenverarbeitungseinrichtungen nicht mehr von der zentralen Steuereinheit angesteuert werden können. Das so aufgebaute Bussystem besitzt also eine gewisse Toleranz gegenüber Kurzschlüssen.

Der Erfindung liegt nun die Aufgabe zugrunde, eine Vorrichtung der eingangs genannten Art anzugeben, welche bei einem Kurzschluß auf der Busleitung das gesamte Rückhaltesystem soweit wie möglich funktionsfähig erhält.

### Vorteile der Erfindung

Die genannte Aufgabe wird gemäß den Merkmalen des Anspruchs 1 dadurch gelöst, daß jede an die Busleitung angeschlossene Datenverarbeitungseinheit eine Kurzschlußmessung an der Busleitung durchführt. Mit Eintritt eines gemessenen Kurzschlusses wird in der Datenverarbeitung dann eine Zeitmessung gestartet, und die Datenverarbeitungseinheit öffnet einen in ihr vorhandenen Längsschalter, mit dem die Busleitung geschlossen oder unterbrochen werden kann, wenn der gemessene Kurzschluß länger als eine vorgegebene Wartezeit dauert.

Dadurch, daß alle Datenverarbeitungseinheiten, welche zur Ansteuerung verschiedener Rückhalteeinrichtungen dienen, selbst aktiv bei der Ermittlung eines Kurzschlusses mitwirken, kann eine optimale Kurzschlußtoleranz des Rückhaltesystems erreicht werden. Es wird nämlich die Dauer des Kurzschlußes berücksichtigt, so daß bei einem nur kurzzeitigen Kurzschluß das gesamte Rückhaltesystem weiter funktionsfähig gehalten wird und bei einem länger dauernden Kurzschluß zumindest diejenigen Datenverarbeitungseinheiten aktiv bleiben, die zwischen der zentralen Steuereinheit und dem lokalisierten Kurzschluß liegen. Es muß also ein Kurzschluß auf der Busleitung nicht unbedingt zu einem Totalausfall des gesamten Rückhaltesystems führen.

Vorteilhafte Weiterbildungen der Erfindung gehen aus den Unteransprüchen hervor.

So kann die Datenverarbeitungseinheit in einen Reset-Zustand versetzt werden, wenn die gemessene Kurzschlußzeitdauer die Wartezeit, nach der der Längsschalter geöffnet wird, um ein Mehrfaches überschreitet.

Zweckmäßigerweise führt die zentrale Steuereinheit eine Kurzschlußmessung an der Busleitung durch und sie startet mit Eintritt eines Kurzschlusses eine Zeitmessung, wobei sie ihre Stromversorgung für die an der Busleitung angeschlossenen Datenverarbeitungseinheiten abschaltet, wenn die von ihr gemessene Kurzschlußdauer eine vorgegebene Haltezeit überschreitet. Diese Haltezeit ist kleiner als die Wartezeit für das Öffnen der Längsschalter in den Datenverarbeitungseinheiten. Die zentrale Steuereinheit schaltet die Stromversorgung für die Datenverarbeitungseinheiten wieder ein, nachdem diese ihre Längsschalter geöffnet haben. Somit kann der Betrieb derjenigen Datenverarbeitungseinheiten, die zwischen der zentralen Steuereinheit und dem Ort des Kurzschlusses liegen, aufrechterhalten werden.

Wenn die zentrale Steuereinheit einen nach Eintritt eines Kurzschlusses auszusendenden Auslösebefehl für die Rückhalteeinrichtungen mehrfach wiederholt über die Busleitung aussendet, erreicht nach einem sehr kurz andauernden Kurzschluß mit Sicherheit ein Auslösebefehl alle betroffenen Datenverarbeitungseinrichtungen.

### Beschreibung eine Ausführungsbeispiels

Anhand eines in der Zeichnung dargestellten Ausführungsbeispiels wird nachfolgend die Erfindung näher erläutert. Es zeigen:
Figur 1 ein Blockschaltbild eines Rückhaltesystems,
Figur 2 ein Blockschaltbild einer Datenverarbeitungseinheit und
Figur 3 ein Ablaufdiagramm des erfindungsgemäßen Verfahrens.

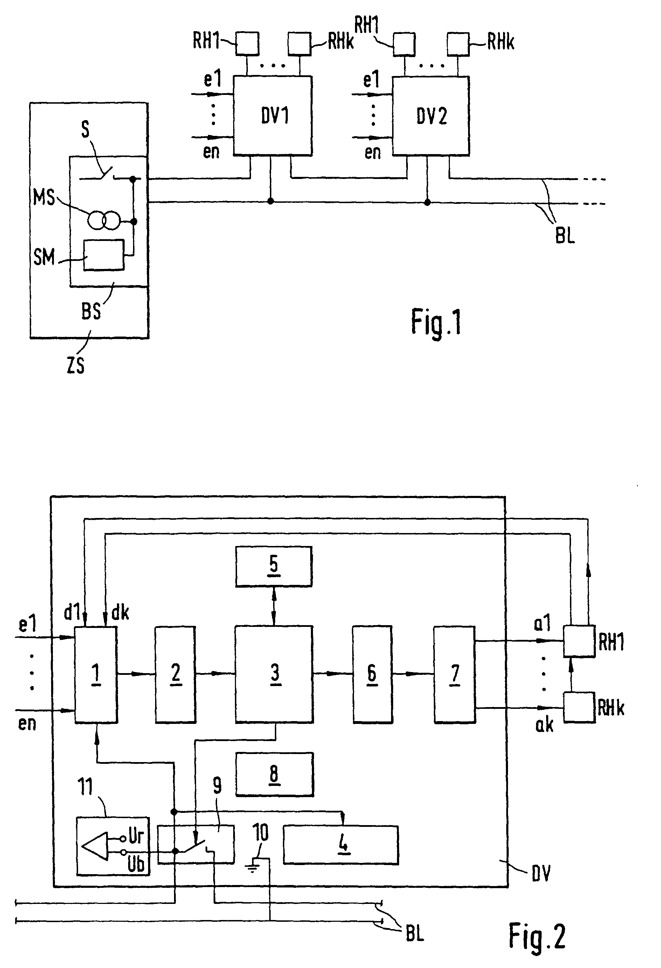

In der Figur 1 ist ein Ausschnitt eines Rückhaltesystems dargestellt, das aus einer zentralen Steuereinheit S, einer daran angeschlossenen Busleitung BL und mehreren mit der Busleitung BL gekoppelten Datenverarbeitungseinheiten DV1, DV2 besteht. Die Busleitung BL ist hier als Stichleitung ausgeführt, sie kann aber genauso gut die Form einer Ringleitung haben. Die zentrale Steuereinheit ZS besitzt neben einer nicht dargestellten Logik- bzw. Signalverarbeitungseinrichtung eine Busschnittstelle BS. Diese Busschnittstelle BS besitzt im wesentlichen einen Längsschalter S, eine Meßstromquelle MS, eine Strommeßeinrichtung SM und auch Signaltreiber, die aber hier nicht dargestellt sind, weil sie für die Erfindung nicht relevant sind. Über den Längsschalter S kann die zentrale Steuereinheit ZS an die Busleitung BL an- oder abgeschaltet werden; d.h. über den Schalter S lassen sich Stromversorgungs- und/oder Steuersignale von der zentralen Steuereinheit ZS auf die Datenverarbeitungseinheiten DV1, DV2 durch- oder abschalten.

Alle Datenverarbeitungseinheiten DV1, DV2, von denen beispielhaft zwei dargestellt sind, besitzen, wie später noch ausführlich dargelegt wird, die gleiche in Figur 2 dargestellte Schaltungsstruktur. Jede der vorhandenen Datenverarbeitungseinheiten DV1, DV2 dient dazu, ein oder mehrere Rückhalteeinrichtungen RH1, ..., RHk anzusteuern. Zu diesen Rückhalteeinrichtungen gehören z.B ein oder mehrstufig zündbare Airbags für den Fahrer und den Beifahrer, Kniebags für Fahrer und Beifahrer, Seitenairbag für Fahrer, Beifahrer und Fond-Insassen, Gurtstrammer usw. Die Datenverarbeitungseinrichtung DV1, DV2 weisen neben den Busleitungsanschlüssen zusätzliche Eingänge e1, ..., en auf, z.B. für Signale von Beschleunigungssensoren und/oder Precrashsensoren und/oder Sitzbelegungssensoren. Diese Datenverarbeitungseinheiten DV1, DV2 sind damit in der Lage, autark ein oder mehrere Rückhalteeinrichtungen RH1, ..., RHk, unabhängig von Steuersignalen der zentralen Steuereinheit ZS, anzusteuern.

In der Figur 2 ist die Schaltungsstruktur einer Datenverarbeitungseinheit DV dargestellt. Die an diese Datenverarbeitungseinheit DV angeschlossene Gruppe von k Rückhalteeinrichtung RH1 bis RHk ist vorzugsweise einem Fahrzeuginsassen zugeordnet. Handelt es sich z.B. um den Beifahrer, dann könnten zu den Rückhaltereinrichtungen RH1 bis RHk ein Frontairbag, ein oder zwei Seitenairbags im Kopf- und Thoraxbereich, ein Kniebag und ein Gurtstrammer gehören, wobei alle Airbags und der Gurtstrammer auch mehrstufig auslösbar sein können.

Für die Rückhalteeinrichtungen RH1, ... RHk generiert die Datenverarbeitungseinheit DV im Crashfall ein Auslösesignal a1 bis ak, wobei die Auswahl der auszulösenden Rückhalteeinrichtungen und die Auslösezeitpunkte in Abhängigkeit von mehreren Eingangssignalen e1 bis en getroffen werden können. Die Eingangssignale e1 bis en stammen von Sensoren, zu denen ein oder mehrere das kinetische Verhalten des Fahrzeugs bei einem Crash erfassende Beschleunigungssensoren, Precrashsensoren, ein Gurtschloßsensor und Sitzbelegungssensoren gehören können. Aus den Sitzbelegungssensorsignalen leitet die Datenverarbeitungseinheit DV ab, ob der Beifahrersitz überhaupt belegt ist, ob ein Kind oder ein Erwachsener dort sitzt und auch welche Sitzhaltung der Beifahrer hat, so daß dementsprechend nur solche Rückhalteeinrichtungen ausgelöst werden, die der Person überhaupt einen Schutz bieten können und sie nicht sogar eher verletzen würden. Ebenso wird die Auslösung der Rückhalteeinrichtungen ganz unterdrückt, wenn der Beifahrersitz gar nicht belegt ist oder sich darauf ein Kindersitz oder Gepäckstück befindet.

In der Figur 2 sind die einzelnen Funktionselemente innerhalb der Datenverarbeitungseinheit DV in Form von Blöcken angedeutet. Es gibt eine Signal-Eingangsschaltung 1 für die Aufnahme analoger oder digitaler Eingangssignale e1 bis en, welche z.B. Signaltreiber und eventuell einen Multiplexer für die Umwandlung parallel anliegender Eingangssignale in einen seriellen Datenstrom enthält. In der anschließenden Datenaufbereitungsschaltung 2 kann eine Analog-Digital-Umsetzung für analoge Eingangssignale erfolgen; in jedem Fall werden hier die Daten so aufbereitet, daß sie von einer nachfolgenden Recheneinheit 3 digital weiterverarbeitet werden können.

Die Recheneinheit 3 erledigt sämtliche Steuerfunktionen in der Datenverarbeitungseinheit DV. Zum Beispiel ermittelt sie aus den Eingangssignalen e1 bis en, welche der angeschlossenen Rückhalteeinrichtungen RH1 bis RHk zu welchen Zeitpunkten ausgelöst werden sollen. Auch führt sie eine Diagnose der Zündelemente in den Rückhalteeinrichtungen RH1 bis RHk durch. Dazu werden Diagnosesignale d1 bis dk - das sind z.B. Widerstandswerte der Zündelemente - der Signal-Eingangsschaltung 1 zugeführt. Die Recheneinheit 3 vergleicht die Diagnosesignale d1 bis dk mit Referenzwerten und gibt bei unzulässigen Abweichungen eine Fehlermeldung aus. Auch wird eine Diagnose einer Energiereserve, die sich in einem Stromversorgungsteil 4 befindet, durchgeführt.

Eine Speichereinheit 5 dient der Aufnahme von temporären Daten, wie z.B. Zündelementwiderstände und Energiezustände der Energiereserve etc.. Ebenso können fertigungspezifische Daten und Kennungsdaten in der Speichereinheit 5 abgelegt werden. Die Recheneinheit 3 kann auf die Daten in der Speichereinheit 5 zugreifen und neue Daten darin einschreiben.

Entsprechend der Eingangsseite der Datenverarbeitungseinheit DV folgen ausgangsseitig nach der Recheneinheit 3 eine Datenaufbereitungsschaltung 6 und eine Signal-Ausgangsschaltung 7. In der Datenaufbereitungsschaltung 6 werden z.B. die digitalen Auslöseinformationen oder Diagnoseabfragesignale aus der Recheneinheit 3 in Zündströme oder Prüfströme für die Zündelemente der Rückhalteeinrichtungen RH1 bis RHk umgesetzt. Die Signal-Ausgangsschaltung 7 ist mit Signaltreibern und eventuell einem Demultiplexer augestattet, der einen seriellen Ausgangssignal-Datenstrom in die einzelnen parallelen Ausgangssignale a1 bis ak aufteilt.

Eine in der Datenverarbeitungseinheit DV vorhandene Zeitund Taktbasis 8 versorgt alle Funktionsblöcke mit einem einheitlichen, synchronen Takt.

Natürlich ist die in Figur 1 dargestellte Aufteilung der Funktionsblöcke nicht zwingend. Es können z.B. die Signal-Eingangsschaltung 1 und Datenaufbereitungssschaltung 2 bzw. die Signal-Ausgangsschaltung 6 und die Datenaufbereitungsschaltung 7 miteinander kombiniert und auch teilweise in der Recheneinheit 3 integriert werden. Ebenso können die Stromversorgung 4 und/oder die Zeit- und Taktbasis 8 in den Datenaufbereitungsschaltungen 2, 6 integriert werden. Es sind viele Möglichkeiten gegeben, mehrere Funktionen in einem Schaltblock zusammenzufassen.

Für die Funktionen der weiter unten noch beschriebenen Erfindung ist aber nicht erforderlich, daß die Datenverarbeitungseinheiten gemäß der vorangehenden Beschreibung autark arbeitende Systeme sind. Auslöseentscheidungen für Rückhalteeinrichtungen können auch ausschließlich von der zentralen Steuereinheit ZS getroffen und den einzelnen Datenverarbeitungseinheiten über die Busleitung BL mitgeteilt werden. Ebenso kann die Diagnose der Rückhalteeinrichtung RH1, ..., RHk und der Datenverarbeitungseinheiten DV1, DV2 von der zentralen Steuereinheit ZS aus veranlaßt werden.

Wie der Figur 2 zu entnehmen ist, ist die Datenverarbeitungseinheit DV mit einem Längsschalter 9 ausgestattet, mit dessen Hilfe die Busleitung BL aufgetrennt und/oder zur nächsten Datenverarbeitungseinrichtung durchgeschaltet werden kann. Das Öffnen und Schließen des Längsschalters 9 wird von der Recheneinheit 3 aus gesteuert. Dabei kann eine Aufforderung zum Schließen oder Öffnen des Längssschalters 9 von der zentralen Steuereinheit ZS über die Busleitung BL übertragen werden. Somit ist es möglich, einzelne Datenverarbeitungseinheiten gezielt anzusprechen und mit Informationen, Steuersignalen und Energiesignalen zu versorgen. Die masseführende Leitung des hier als Zweidradleitung ausgeführten Busses BL ist mit einem gemeinsamen Masseanschluß 10 in der Datenverarbeitungseinheit DV kontaktiert. Von der anderen Leitung des Buses BL werden die von der zentralen Steuereinheit ZS ausgesendeten Informations- und Steuersignale der Signal-Eingangsschaltung 1 und die Energieversorgungssignale dem Stromversorgungsteil 4 zugeführt.

In der Datenverarbeitungseinheit DV ist ein Komparator 11 vorhanden, der die Spannung Ub auf der Busleitung BL abgreift und mit einer Referenzspannung Ur vergleicht. Über diesen Vergleich läßt sich feststellen, ob die Busspannung Ub auf Grund eines Kurzschlusses auf der Busleitung BL zusammengebrochen ist.

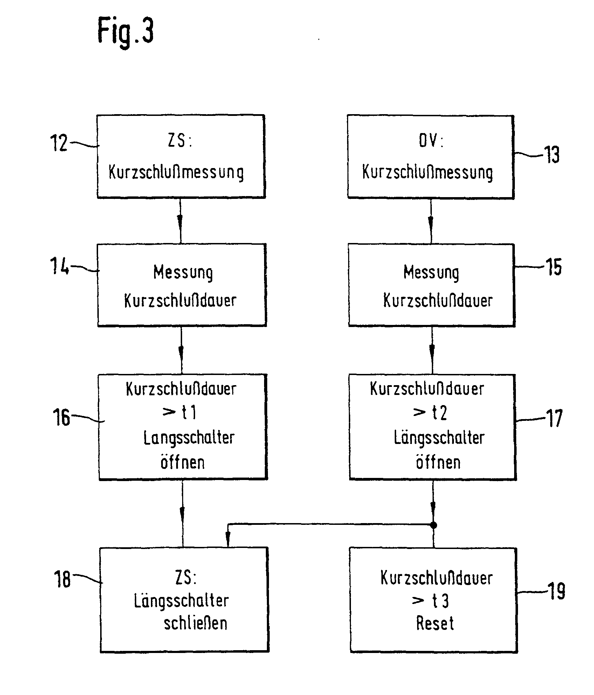

Nun wird anhand des Ablaufdiagramms in Figur 3 beschrieben, wie die Datenverarbeitungseinheiten DV und die zentrale Steuereinheit ZS im Falle eines Kurzschlusses verfahren, um das gesamte Rückhaltesystem soweit wie möglich funktionsfähig zu erhalten. Wie in den Blöcken 12 und 13 angedeutet, führen sowohl die zentrale Steuereinheit ZS als auch alle Datenverarbeitungseinheiten DV eine Kurzschlußmessung auf der Busleitung BL durch. Dabei erfolgt in den Datenverarbeitungseinheiten DV, wie gesagt, die Kurzschlußmessung mit Hilfe eines Spannungskomparators 11. Die zentrale Steuereinheit ZS besitzt für die Kurzschlußmessung in ihrer Busschnittstelle BS eine Meßstromquelle MS und eine Strommeßeinrichtung SM. Sobald ein Kurzschluß auf der Busleitung BL entsteht, erkennt die Strommeßeinrichtung SM eine Veränderung des in die Busleitung von der Meßstromquelle MS eingespeisten Stroms.

Gemäß den Blöcken 14 und 15 führen sowohl die zentrale Steuereinheit als auch die Datenverarbeitungseinheiten eine Messung der Kurzschlußdauer durch. Dabei wird in der zentralen Steuereinheit ZS und in den Datenverarbeitungseinheiten DV mit Eintritt eines gemessenen Kurzschlusses auf der Busleitung eine Zeitmessung gestartet. Mißt die zentrale Steuereinheit ZS gemäß dem Block 16 eine Kurzschlußdauer, die größer als eine Zeit t1 ist, so öffnet sie ihren Längsschalter S. Diese Haltezeit t1 beträgt z.B. 100 Microsekunden. Wenn der Längsschalter S in der zentralen Steuereinheit ZS geöffnet ist, sind die Datenverarbeitungseinheiten DV von der Energieversorgung der zentralen Steuereinheit ZS abgetrennt. Dann beziehen die Datenverarbeitungeinheiten DV ihre Energie aus der Energiereserve ihres Stromversorgungsteils 4. Löst sich der Kurzschluß in einer Zeit, die kleiner als die Haltezeit t1 ist, wieder auf, so bleibt das gesamte Rückhaltesystem unbeschadet. Denn die zentrale Steuereinheit ZS sendet Auslösebefehle mehrfach hintereinander, so daß einer der mehrfach gesendeten Auslösebefehle nach dem Kurzschluß sicher die betroffenen Datenverarbeitungseinheiten DV erreicht.

Entsprechend Block 17 des Ablaufdiagramms öffnen die Datenverarbeitungseinheiten DV ebenfalls ihre Längsschalter 9, wenn sie eine Kurzschlußdauer messen, die größer als eine Zeit t2 ist. Diese Wartezeit t2 beträgt ca. 1 Millisekunde. Die beiden Zeiten t1 und t2 für die Längsschhalteröffnung sind deshalb so unterschiedlich gewählt, um ein Wechselspiel zwischen den Schaltvorgängen in der zentralen Steuereinheit ZS und in den Datenverarbeitungseinheiten DV zu vermeiden, so daß es nicht zu einem Schwingverhalten in dem gesamten Bussystem kommt. Die Vorgabe der beiden Zeiten t1 und t2 richtet sich nach der kleinsten Auslösereaktionszeit in dem Rückhaltesystem; maßgebend dabei ist vor allem die sehr geringe Auslösezeit für Seitenairbags.

Das Öffnen der Längsschalter 9 in den Datenverarbeitungseinheiten DV hat die Wirkung, daß der Kurzschluß für die zentrale Steuereinheit ZS aufgehoben wird. Denn wenn an einer Stelle vor dem Kurzschluß die Busleitung durch einen oder mehrere Längsschalter 9 der Datenverarbeitungseinheiten DV unterbrochen wird, erkennt die zentrale Steuereinheit ZS keinen Kurzschluß mehr. Dann wird die zentrale Steuereinheit ZS gemäß Block 18 ihren Längsschalter S wieder schließen und es kann wieder ein Versorgungsstrom zumindest für diejenigen Datenverarbeitungseinheiten DV fließen, welche zwischen der zentralen Steuereinheit ZS und dem Ort des Kurzschlusses liegen. Somit ist das Rückhaltesystem zumindest zum Teil noch funktionsfähig.

Ist aber die in den Datenverarbeitungseinheiten DV gemessene Kurzschlußdauer länger als eine vorgegebene Zeit t3, so ist die Energiereserve in den Datenverarbeitungseinheiten DV verbraucht und alle Datenverarbeitungseinheiten DV führen einen Reset durch, wie im Block 19 angedeutet. Die Zeit t3 ist kleiner als 1 Sekunde.

## Patentansprüche

1. Verfahren zum Betreiben eines über eine Busleitung (BL) vernetzten Rückhaltesystems bei einem Kurzschluß auf der Busleitung, wobei an die Busleitung eine zentrale Steuereinheit (zs) und mehrere Datenverarbeitungseinheiten (DV, DV1, DV2) angekoppelt sind, von denen jede zur Ansteuerung ein oder mehrerer Rückhalteeinrichtungen (RH1, ...., RHk) vorgesehen ist, **dadurch gekennzeichnet, daß** jede Datenverarbeitungseinheit (DV, DV1, DV2) eine Kurzschlußmessung an der Busleitung (BL) durchführt, daß in der Datenverarbeitungseinheit (DV, DV1, DV2) mit Eintritt eines gemessenen Kurzschlusses auf der Busleitung (BL) eine Zeitmessung gestartet wird, und daß die Datenverarbeitungseinheit (DV, DV1, DV2) einen in ihr vorhandenen Längsschalter (9), mit dem die Busleitung (BL) geschlossen oder unterbrochen werden kann, öffnet, wenn der gemessene Kurzschluß länger als eine vorgegebene Wartezeit dauert.

2. Verfahren nach Anspruch 1, **dadurch gekennzeichnet, daß** die Datenverarbeitungseinheit (DV, DV1, DV2) in einen Reset-Zustand versetzt wird, wenn die gemessene Kurzschlußzeitdauer die Wartezeit, nach der der Längsschalter geöffnet wird, um ein Mehrfaches überschreitet.

3. Verfahren nach Anspruch 1, **dadurch gekennzeichnet, daß** die zentrale Steuereinheit (ZS) eine Kurzschlußmessung an der Busleitung (BL) durchführt, daß sie mit Eintritt eines Kurzschlusses eine Zeitmessung startet, daß die zentrale Steuereinheit (ZS) ihre Stromversorgung für die an die Busleitung (BL) angeschlossenen Datenverarbeitungseinheiten (DV, DV1, DV2) abschaltet, wenn die von ihr gemessene Kurzschlußdauer eine vorgegebene Haltezeit überschreitet, welche kleiner als die Wartezeit für das Öffnen der Längsschalter (9) in den Datenverarbeitungseinheiten (DV, DV1, DV2) ist, und daß die zentrale Steuereinheit (ZS) die Stromversorgung für die Datenverarbeitungseinheiten (DV, DV1, DV2) wieder einschaltet, nachdem diese ihre Längsschalter (9) geöffnet haben.

4. Verfahren nach Anspruch 1 oder 2, **dadurch gekennzeichnet, daß** die zentrale Steuereinheit (ZS) einen nach Eintritt eines Kurzsschlusses auszusendenden Auslösebefehl für die Rückhaltereinrichtung (RH1, ... RHk) mehrfach wiederholt über die Busleitung (BL) aussendet.

## Claims

1. Method for operating a restraint system connected via a bus line (BL), when there is a short-circuit on the bus line, a central control unit (25) and a plurality of data processing units (DV, DV1, DV2) being coupled to the bus line, each of which data processing units (DV, DV1, DV2) being provided for actuating one or more restraint devices (RH1, ..., RHk), **characterized in that** each data processing unit (DV, DV1, DV2) carries out a short-circuit measurement on the bus line (BL), **in that** a time measurement is started in the data processing unit (DV, DV1, DV2) when a measured short-circuit occurs on the bus line (BL), and **in that** the data processing unit (DV, DV1, DV2) opens a longitudinal switch (9) which is present in it and with which the bus line (BL) can be closed or disconnected if the measured short-circuit lasts longer than a predefined waiting time.

2. Method according to Claim 1, **characterized in that** the data processing unit (DV, DV1, DV2) is placed in a resetting state if the measured short-circuit time period exceeds the waiting time after which the longitudinal switch is opened by a multiple.

3. Method according to Claim 1, **characterized in that** the central control unit (ZS) carries out the short-circuit measurement on the bus line (BL), **in that** it starts a time measurement when a short-circuit occurs, **in that** the central control unit (ZS) switches off its power supply for the data processing unit (DV, DV1, DV2), connected to the bus line (BL), if the short-circuit period measured by said data processing unit (DV, DV1, DV2) exceeds a predefined holding time which is shorter than the waiting time for the opening of the longitudinal switches (9) in the data processing unit (DV, DV1, DV2), and **in that** the central control unit (ZS) switches on the power supply for the data processing unit (DV, DV1, DV2) again after they have opened their longitudinal switches (9).

4. Method according to Claim 1 or 2, **characterized in that** the central control unit (ZS) repeatedly outputs over the bus line (BL) a triggering instruction for the restraint device (RH1, ... RHk), which triggering instruction is to be output after a short-circuit occurs.

## Revendications

1. Procédé de mise en oeuvre d'un système de retenue relié par une ligne de bus (BL) en cas de court-circuit sur la ligne de bus, selon lequel une unité de commande centriale (ZS) et plusieurs unités de traitement de données (DV, DV1, DV2) sont reliées à la ligne de bus et dont chacune est destinée à commander une ou plusieurs installations de retenue (RH1, ..., RHk),
**caractérisé en ce que**
chaque unité de traitement de données (DV, DV1, DV2) effectue une mesure de court-circuit sur la ligne de bus (BL),
lorsqu'un court-circuit est mesuré par l'unité de traitement de données (DV, DV1, DV2) sur la ligne de bus (BL) elle démarre une mesure de temps, et
l'unité de traitement de données (DV, DV1, DV2) ouvre un commutateur de durée (9) relié à cette unité, et permettant de brancher ou de couper la ligne de bus (BL) si le court-circuit mesuré a une durée supérieure à une durée d'attente prédéterminée.

2. Procédé selon la revendication 1,
**caractérisé en ce que**
l'unité de traitement de données (DV, DV1, DV2) est mise dans un état de remise à l'état initial si la durée du court-circuit dépasse un multiple du temps d'attente après lequel on ouvre l'interrupteur de durée.

3. Procédé selon la revendication 1,
**caractérisé en ce que**
l'unité de commande centrale (ZS) effectue une mesure de court-circuit sur la ligne de bus (BL),
et à l'arrivée d'un court-circuit elle démarre une mesure de temps,
l'unité centrale de commande (ZS) coupe son alimentation électrique des unités de traitement de données (DV, DV1, DV2) reliées à la ligne de bus (BL) si la durée de court-circuit qu'elle a mcsurée dépasse une durée de maintien prédéterminée inférieure à la durée d'attente pour l'ouverture de l'interrupteur de durée (9) dans les unités de traitement de données (DV, DV1, DV2), et
l'unité de commande centrale (ZS) rebranche l'alimentation électrique des unités de traitement de données (DV, DV1, DV2) après que celles-ci aient ouvert leur commutateur de durée (9).

4. Procédé selon la revendication 1 ou 2,
**caractérisé en ce que**
l'unité centrale de commande (ZS) émet de façon répétée par la ligne de bus (BL), un ordre de déclenchement à envoyer après l'arrivée d'un court-circuit pour l'installation de retenue RH1, ...RHk).
